# EUROPEAN PATENT APPLICATION

(11) **EP 0 568 177 A2**
(43) Date of publication of application: **03.11.1993**
(21) Application number: 93301449.0
(22) Date of filing: 26.02.1993
(51) Int. Cl.: C30B 23/02, C30B 29/48

(54) **Epitaxial growth method and apparatus for doping nitrogen**

(30) Priority: 28.02.1992 JP 44102/92
(71) Applicant: SONY CORPORATION, Tokyo (JP)
(72) Inventor: Ito, Satoshi, Shinagawa-ku, Tokyo (JP); Ikeda, Masao, Shinagawa-ku, Tokyo (JP); Akimoto, Katsuhiro, Shinagawa-ku, Tokyo (JP)
(74) Representative: Nicholls, Michael John

(57) **Abstract**

An epitaxial growth system comprises a vacuum vessel, a plasma generating apparatus for exciting a doping gas, a source for supplying the doping gas and a substrate within the vacuum vessel on which a semiconductor is being grown or after having been grown, wherein the doping gas-supply source includes an aperture for doping a part of the doping gas into the substrate and an aperture for exhausting a remaining portion of the doping gas into the vacuum vessel.

An epitaxial growth method comprises the steps of growing or having been growing a semiconductor on a substrate within a vacuum vessel by an epitaxy method, doping a part of gas supplied from a doping gas supply source into the substrate during or after the semiconductor is grown, and exhausting a remaining gas into the vacuum vessel, wherein the gas doped into the substrate is made at least to be a plasma gas.

An epitaxial growth method comprises the steps of depositing a first element selected from at least one of Hg, Mg, Zn and Cd and a second element selected from at least one of S, Se and Te on a substrate within a vacuum vessel, and irradiating an excited species of nitrogen, oxygen molecule or atom excited by an electron-cyclotron-resonance (ECR) plasma on the substrate.

## Description

The present invention relates to epitaxial growth method and apparatus for doping nitrogen.

Recently, it has been proposed to increase a recording density in optical recording and reproduction, magneto-optical recording and reproduction or the like by shortening the wavelength of laser light used. Therefore, a need has arisen for a short wavelength laser such as a blue light emitting semiconductor laser or the like. As a blue light emitting semiconductor laser, a II-VI compound semiconductor of ZnSe system, for example, formed of II-group element such as zinc, mercury, cadmium, magnesium or the like and VI-group element such as sulfur, selenium, tellurium or the like has received attention.

To make a II-VI compound semiconductor have a P-type conductivity, there is known a method for adding nitrogen (N) thereto as an impurity (e.g., Physics. Review. B Vol. 27, PP.2419 - 2428 (1983)).

Further, as a method for adding nitrogen, there is known a method for irradiating nitrogen molecule or neutral excited species of ammonium molecule (e.g., Japanese Laid-Open Patent Publication Nos. 63-303899 and 63-303889). Furthermore, as a method for adding nitrogen, there is known a method for irradiating ion species (see Japanese Laid-Open Patent Publication No. 63-227027).

In epitaxial growth apparatus such as an MBE (molecular beam epitaxy) apparatus using plasma decomposition, a very small flow rate of a plasma generating source is generally controlled by a variable leak valve. This flow rate is calculated on the basis of an exhaust speed and a vacuum degree within a vacuum chamber. The vacuum degree within the vacuum chamber, however, tends to change with deterioration of exhaust ability, temperature distribution of liquid nitrogen shroud covering the inside of the vacuum chamber or the like so that the flow rate cannot be reproduced with high accuracy. Further, since the variable leak valve adjusts the flow rate by a pressing operation, it is frequently observed that the actual flow rate fluctuates with respect to the graduation of the supply rate. Therefore, it is very difficult to adjust a very small flow rate of introduced gas by using such variable leak valve with high accuracy and high reproducibility.

The doping amount to the semiconductor is very sensitive to the above flow rate so that, if the flow rate of introduced gas changes, then it becomes extremely difficult in the above semiconductor laser to dope a very small amount of nitrogen into the crystal by plasma decomposition with satisfactory reproducibility.

Furthermore, in the prior art an RF plasma has been used as a beam source of an excited species (radical). The electric power applied to an RF plasma generating apparatus is large and the RF plasma generating apparatus generates much heat. As a result, when the II-VI compound semiconductor is formed under the vacuum condition of high vacuum degree, impurity gases such as nitrogen, oxygen, H20 or the like adsorbed to the inner and outer walls of the RF plasma generating apparatus are separated from the inner and outer walls and absorbed in the II-VI compound semiconductor as impurities. There is then the disadvantage that a bad influence is exerted upon an electrical characteristic of the semiconductor layer.

Accordingly, it is an object of the present invention to provide an improved epitaxial growth method and apparatus for doping nitrogen in which the aforesaid shortcomings and disadvantages encountered with the prior art can be eliminated.

More specifically, it is an object of the present invention to provide an epitaxial growth method and apparatus for doping nitrogen in which an amount of gas doped into a compound semiconductor can be controlled accurately and easily.

It is another object of the present invention to provide an epitaxial growth method and apparatus for doping nitrogen in which the occurrence of impurity gas from a plasma generating apparatus can be suppressed.

According to a first aspect of the present invention, there is provided an epitaxial growth system which comprises a vacuum vessel, a plasma generating apparatus for exciting a doping gas, a source for supplying the doping gas, and a substrate within the vacuum vessel on which a semiconductor layer is being grown or after having been grown, wherein the doping gas supply source includes an aperture for doping a part of the doping gas into the semiconductor layer and an aperture for exhausting a remaining portion of the doping gas into the vacuum vessel.

According to a second aspect of the present invention, there is provided an epitaxial growth method which comprises the steps of growing or having been growing a semiconductor layer on a substrate within a vacuum vessel by an epitaxy method, doping a part of gas supplied from a doping gas supply source into the semiconductor layer during or after the semiconductor layer is grown, and exhausting a remaining gas into the vacuum vessel, wherein the gas doped into the semiconductor layer is made at least to be a plasma gas.

According to a third aspect of the present invention, there is provided an epitaxial growth method which comprises the steps of depositing a first element selected from at least one of Hg, Mg, Zn and Cd and a second element selected from at least one of S, Se and Te on a substrate within a vacuum vessel, and irradiating an excited species of nitrogen, oxygen molecule or atom excited by an electron-cyclotron-resonance (ECR) plasma on the substrate.

The different aspects of the invention as defined above and in the claims may advantageously be combined together as can the optional features defined in the dependent claims attached hereto.

The present invention will be further described in the following detailed description of illustrative embodiments thereof given by way of example and to be read in conjunction with the accompanying drawings in which:
FIG. 1 is a diagram showing a structure of an epitaxial growth apparatus according to an embodiment of the present invention;
FIG. 2 is a cross-sectional view showing a main portion of the epitaxial growth apparatus according to the embodiment of the present invention;
FIG. 3 is a diagram showing a main portion of the epitaxial growth apparatus according to another embodiment of the present invention;
FIG. 4 is a diagram showing a molecular beam epitaxy (MBE) apparatus for use in a manufacturing method of a semiconductor device according to the present invention;
FIG. 5 is a diagram used to explain the manufacturing method according to the present invention; and
FIGS. 6 and 7 are graphs used to explain the present invention, respectively.

Embodiments of an epitaxial growth apparatus and a method thereof according to the present invention will hereinafter be described with reference to the drawings. In the embodiments of the present invention, nitrogen is doped into a p-type cladding layer of the ZnSe II-VI compound semiconductor.

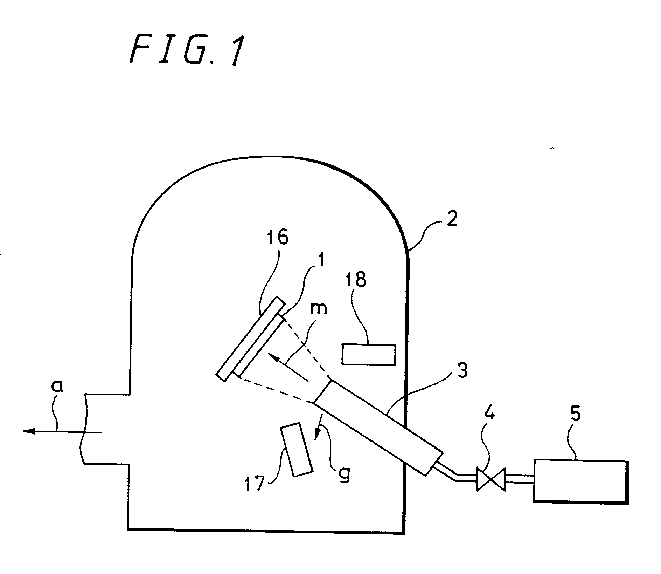

FIG. 1 shows an overall arrangement of an epitaxial growth apparatus according to the present invention. The inside of a vacuum vessel 2 is exhausted to a predetermined vacuum degree of, for example, about 10⁻⁹ Torr by an exhausting system (not shown) as shown by an arrow a in FIG. 1. A substrate 1 is supported on a substrate holder 16 within the vacuum vessel 2 and a high frequency (RF) or electron cyclotron resonance (ECR) plasma generating source 3 is disposed in an opposing relation to the substrate 1. Nitrogen gas from a high purity nitrogen cylinder or nitrogen purifying apparatus (not shown) is introduced into the vacuum vessel 2 through a supply rate control unit 5 such as a mass-flow controller or the like. One portion of the rear stage of the control unit 5 is branched to exhaust nitrogen gas into the vacuum vessel 2 as shown by an arrow g in FIG. 1. In FIG. 1, an arrow m shows an irradiation direction of nitrogen gas molecule. In FIG. 1, reference numerals 17, 18 depict molecular beam apparatus, respectively.

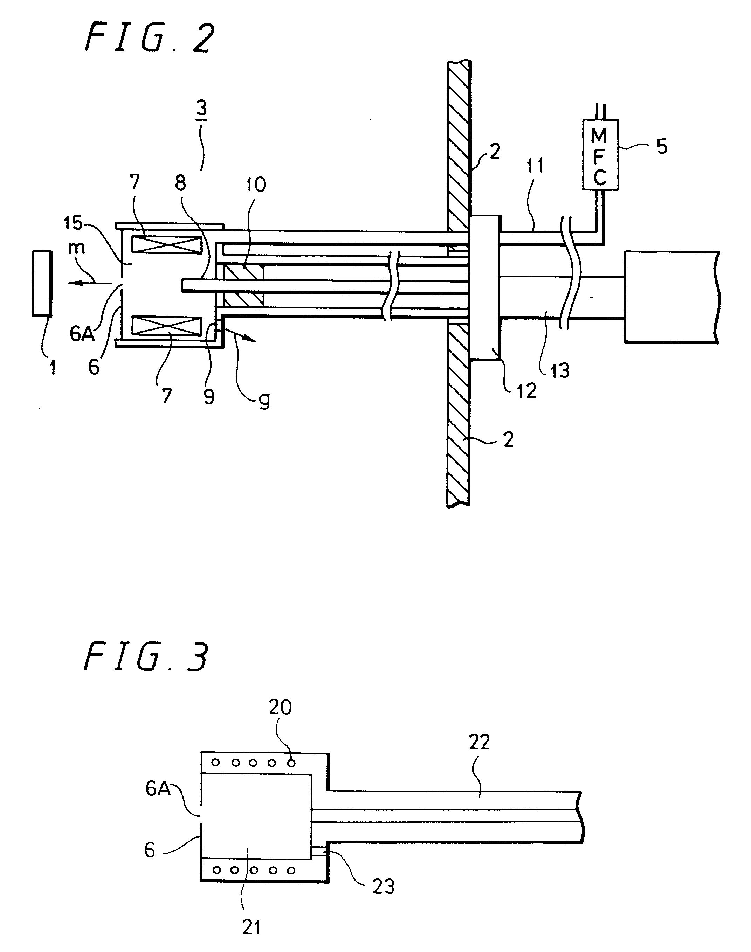

FIG. 2 shows an example of the plasma generating apparatus 3. In FIG. 2, like parts corresponding to those of FIG. 1 are marked with the same references and therefore need not be described in detail. As shown in FIG. 2, from the plasma generating apparatus 3 at its top portion opposing the substrate 1, plasma is generated within a plasma generating chamber 15 by microwave introduced by a microwave antenna 8. Nitrogen gas introduced from a gas conduit 11 is separated or excited in the plasm generating chamber 15 and radiated toward the substrate 1 through an aperture 6A formed through a partition wall 6 of the plasma generating chamber 15 and serving as an irradiation outlet. In this embodiment, an area of the aperture 6A is 1.0 x 10⁻³ to 1.0 mm². In FIG. 2, reference numeral 7 depicts a magnet, 10 a sealing member for confining gas, 12 a flange, and 13 a terminal through which microwaves are introduced.

The plasma generating chamber 15 has a gas exhaust hole 9 bored through its side wall opposite to the irradiation outlet. In order to protect the substrate 1 from being directly radiated with nitrogen gas, the nitrogen gas is branched through the fast exhaust hole 9 and the branched nitrogen gas is exhausted into the vacuum vessel 2 as shown by the arrow g in FIG. 1.

In this embodiment, when ZnSe compound semiconductor was grown, the doping of nitrogen thereinto was carried out under the condition that the supply rate of nitrogen gas was controlled by the supply rate control unit 5 such as the mass-flow controller or the like while the nitrogen gas was exhausted. In this case, a substrate temperature was selected to be 295°C, a beam intensity ratio of Zn and Se was selected to be 1/1.2, a nitrogen gas flow rate was selected to be 0.2 cm³/minute and plasma of 50W was generated. When the doping was carried out under the aforementioned conditions, the inside of the vacuum vessel 2 was reached to a relatively low vacuum degree of about 1 x 10⁻⁵ Torr, i.e., high pressure. According to respective test samples 1 to 3, their p-type cladding layers having carrier concentration of about 2.5 x 10¹⁷/cm³ could be formed with satisfactory reproducibility.

The measured results are illustrated on the table 1 below.

**TABLE 1**

| | Carrier Concentration(cm⁻³) |
|---|---|
| Text Sample 1 | 2.5 x 10¹⁷ |
| Text Sample 2 | 2.4 x 10¹⁷ |
| Text Sample 3 | 2.6 x 10¹⁷ |

FIG. 3 shows a structure of a main portion of the epitaxial growth apparatus utilizing an RF plasma generating apparatus according to another embodiment of the present invention. In FIG. 3, reference numeral 20 depicts an RF coil, 21 a plasma generating chamber and 22 a gas conduit. Reference numeral 6 designates a partition wall of the plasma generating chamber 21 with an aperture 6A as an irradiation outlet similar to the example shown in FIG. 2. Also in this case, the plasma generating chamber 21 has a gas exhaust hole 23 bored through the inner wall opposite to the plasma irradiation outlet. Nitrogen gas is branched through the gas exhaust hole 23 and a part of nitrogen gas is exhausted into the vacuum vessel 2. Then, the whole flow rate of nitrogen gas was controlled by the supply rate control unit 5 such as the mass-flow controller or the like, whereby a carrier concentration could be controlled with satisfactory reproducibility.

While the gas exhaust hole is provided on the opposite side to the irradiation outlet of the plasma generating chamber as described above, the present invention is not limited thereto and such a variant is also possible. That is, when the gas exhaust hole was provided through the side wall of the plasma generating chamber and through the gas conduit within the vacuum vessel 2 or the like, the carrier concentration could be similarly controlled with satisfactory reproducibiliy without affecting the crystal growth on the substrate.

When such gas exhaust hole is formed through the gas conduit provided outside the vacuum vessel 2, an exhaust system must be connected to the gas exhaust hole. There is then the risk that a vacuum degree within the vacuum vessel 2 will fluctuate. According to the present invention, since the gas is exhausted into the vacuum vessel 2, another exhaust system need not be connected to the gas exhaust hole, i.e., vacuum degree can be prevented from fluctuating, thereby making it possible to control the flow rate of the gas with high accuracy.

While nitrogen gas is doped into the ZnSe system compound semiconductor as described above, the present invention is not limited thereto and may be applied to the case that various II-VI compound semiconductors such as ZnTe II-VI semiconductor, Mg II-VI semiconductor or the like are grown. It is needless to say that the growth apparatus and the growth method of the present invention are not limited to the aforesaid embodiment and various changes and modifications could be effected therein.

As described above, according to the embodiment of the epitaxial growth apparatus of the present invention, since the nitrogen gas is exhausted into the vacuum vessel 2 via the branched portion that is at the rear stage of the supply rate control unit 5, the whole supply rate of the nitrogen gas can be made relatively large. Therefore, the flow rate control means of high accuracy such as the mass-flow controller or the like can be used so that the nitrogen doping amount can be controlled with satisfactory reproducibility.

Further, according to the embodiment of the epitaxial growth method of the present invention, since the nitrogen gas is branched at the rear stage of the supply rate control unit 5 after the vacuum vessel 2 was exhausted to the predetermined vacuum degree, the whole flow rate can be made large and the flow rate can be controlled with satisfactory accuracy, whereby the doping amount of nitrogen gas can be controlled with satisfactory reproducibility.

Furthermore, since a part of nitrogen gas is exhausted into the vacuum vessel 2, a new exhaust system need not be provided, thereby avoiding the vacuum degree within the vacuum vessel 2 from fluctuating.

A third embodiment of the present invention will be described below. In the third embodiment, a p-ZnSe layer formed of ZnSe to which nitrogen (N) is added as impurity is formed. In this case, selenium (Se) was selected as a first element and zinc (Zn) was selected as a second element. A nitrogen molecule was utilized as an excited species and an n-GaAS substrate was utilized as a substrate.

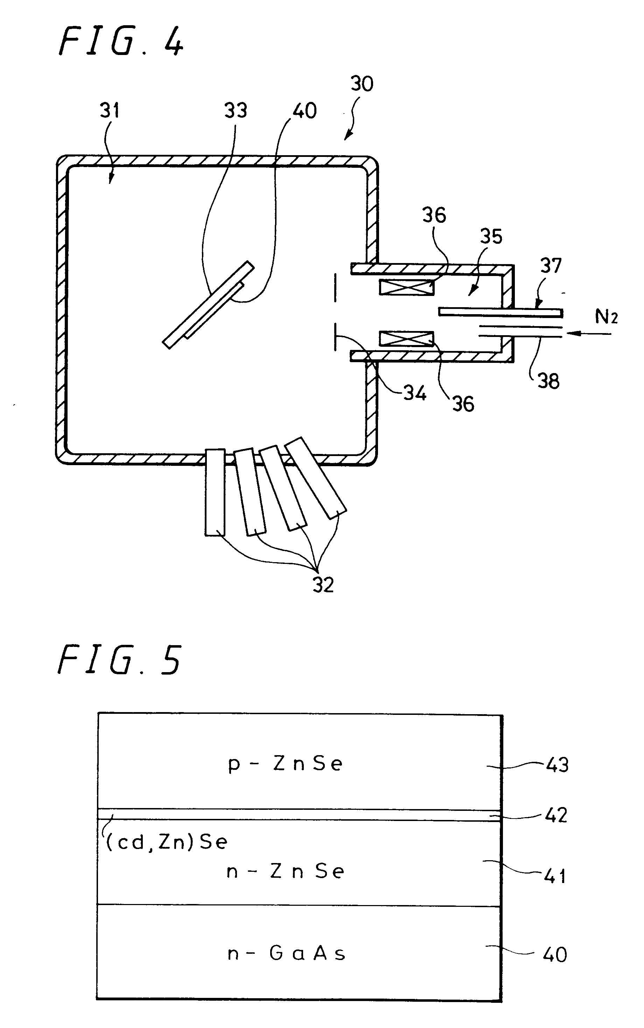

FIG. 4 schematically shows an arrangement of a molecular beam epitaxy (MBE) apparatus 30 which is suitable for use with a manufacturing method of semiconductor device according to the present invention. The MBE apparatus 30 is a kind of vacuum evaporating apparatus and includes a vacuum vessel 31 having an ultra-high vacuum exhausting apparatus (not shown). The vacuum vessel 31 incorporates therein a plurality of molecular beam sources (K cells) 32 and a substrate holder 33 for holding a substrate 40.

One of the most specific features of the MBE apparatus 30 lies in that it includes an ECR cell 35 which comprises a permanent magnet 36 and a microwave antenna 37. That is, the plasma generating apparatus includes the ECR cell 35. The permanent magnet 36 can be replaced with an electromagnet. A magnetic force of the magnet can be selected to b 8.75 x 10⁻²T.

Nitrogen (N₂) is highly purified by using an adsorption tube (not shown). The nitrogen is introduced into the ECR cell 35 through a gas conduit 38 made of a stainless steel. A 2.45 GHz microwave is introduced into the ECR cell 35 by means of the microwave antenna 37. A plasma gas (excited species of nitrogen molecule) generated within the ECR cell 35 is exhausted into the vacuum vessel 31 via an aperture 34.

A manufacturing method of semiconductor device according to the present invention will be described below.

Utilizing the apparatus shown in FIG. 4, the n-GaAs substrate 40 whose surface had been cleaned was mounted on the substrate holder 33. After the vacuum vessel 31 was exhausted to about 10⁻⁸Pa, according to the conventional method, as shown in FIG. 5, an n-ZnSe first cladding layer 41 was formed on the substrate 40. Further, a (Cd, Zn) Se active layer 42 was formed on the first cladding layer 42 (see FIG. 5).

Then, according to the manufacturing method of semiconductor device of the present invention, as shown in FIG. 5, a p-ZnSe second cladding layer 43 was formed on the active layer 42. Zinc and selenium of high purity were independently filled into the respective K cells 32 in advance. Then, the K cells 32 were heated so that they are adjusted to present proper molecular beam intensities, respectively. The molecular beam intensity of zinc and selenium was selected to be 1 : 1.2

A temperature of the substrate 40 was selected to be 300°C. Then, selenium (Se) serving as the first element and zinc (Zn) serving as the second element were deposited on the substrate 40. That is, a crystal formed of the first element (Se) and the second element (Zn) was grown on the active layer 42. At the same time when the crystal was grown on the active layer 42, the excited species of nitrogen molecule was radiated on the substrate 40 from the ECR cell 35. Thus, a semiconductor device shown in a schematic cross-sectional view of FIG. 5 could be manufactured.

An amount of the radiated excited species (plasma) which is doped into the II-VI compound semiconductor can be controlled by changing either an electric power applied to the ECR cell 35 or the opening area of the aperture 34. To change the opening area of the aperture 34, the vacuum state of vacuum vessel 2 must be broken, returned to atmospheric pressure and then the aperture must be exchanged. It takes a few weeks to evacuate the vacuum vessel 21 to high degree after the aperture was exchanged. Therefore, the amount of nitrogen doped into the II-VI compound semiconductor crystal must be changed in a wide range by changing an electric power applied to the ECR cell 35.

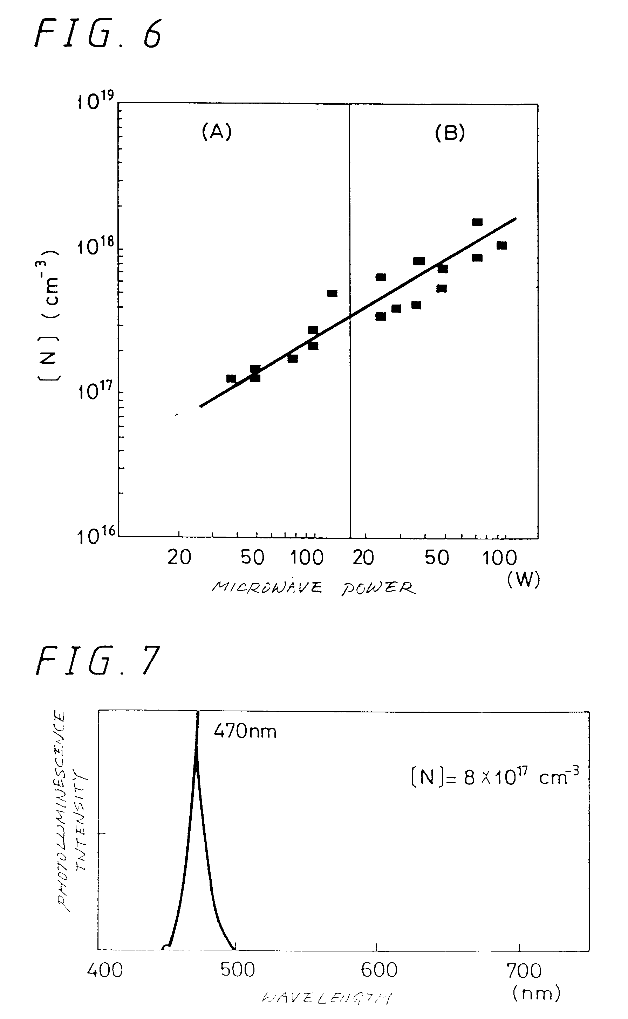

As shown in FIG. 6, according to the semiconductor device manufacturing method using the ECR plasma of the present invention, the amount of nitrogen doped can be controlled in a wide range and an acceptor representative of p-type conductivity can be introduced into the II-VI compound semiconductor crystal effectively and accurately. A (A) in FIG. 6 shows measured results in the case that the opening area of the aperture was selected to be 8 x 10⁻³ mm² and a (B) in FIG. 6 shows measured results in the case that the opening area of the aperture was selected to be 7 x 10⁻² mm². In the II-VI compound semiconductor made of ZnSe, for example, Se and N in the ZnSe crystal is replaced with N so that, as the amount of N in the ZnSe crystal increases, the amount of Se decreases. Therefore, it is sufficient that an irradiation density (density of N element in the II-VI compound semiconductor) at which excited species of nitrogen molecule is radiated onto the substrate 40 is 10⁻⁶ to 10⁻³ times the deposition density (density of Se element in the II-VI compound semiconductor) in which Se is deposited on the substrate 40.

In addition, as shown in FIG. 6, the electric power applied to the ECR cell 35 is about half as compared with the electric power (generally 150 to 300W) applied to the RF plasma generating apparatus. When the electric power applied to the plasma generating apparatus is increased, a temperature of the plasma generating apparatus is increased. As a consequence, the plasma generating apparatus generates impurity gas and this impurity gas is absorbed into the crystal so that the quality of the compound semiconductor layer is degraded. According to the method using the ECR plasma of the present invention, the ECR cell 35 serving as the plasma generating apparatus can be operated with a small electric power, thereby suppressing the occurrence of impurity gas. Consequently, there can be obtained a semiconductor device of high quality because photoluminescence of deep level near 600 nm caused by impurities was not observed as shown in FIG. 7.

A fourth embodiment of the present invention will be described below. In the fourth embodiment, nitrogen (N) was added as an impurity and a p-(Mg, Zn) (S, Se) layer was formed. More specifically, sulfur (S) and selenium (Se) were selected as the first element and magnesium (Mg) and zinc (Zn) were selected as the second element. Nitrogen molecule was utilized as the excited species and an n-GaAs substrate was utilized as the substrate.

Utilizing the apparatus shown in FIG. 4, the n-GaAs substrate 40 whose surface had been cleaned was mounted on the substrate holder 33. After the vacuum vessel 31 was evacuated to about 10⁻⁶Pa, according to the conventional method, an n-(Mg, Zn)(S, Se) first cladding layer was formed on the substrate 40 and a ZnSe active layer was formed on the first cladding layer.

Then, on the basis of the semiconductor device manufacturing method according to the present invention, a p-(Mg, Zn)(S, Se) second cladding layer was formed on the active layer. Magnesium, Zinc, sulfur and selenium of high purity serving as raw materials were respectively filled into the K cells 32 in advance. Then, the K cells 32 were heated so that they area adjusted to present proper molecular beam intensities, respectively. In this case, the molecular beam intensity ratio among magnesium, zinc, sulfur and selenium was selected to be 0.2 : 1 : 0.1 : 1.2.

A temperature of the substrate 40 was selected to be 300°C and then sulfur (S) and Selenium (Se) serving as the first element and magnesium (Mg) and Zinc (Zn) serving as the second element were deposited on the substrate 40, i.e., a crystal made of the first element (S, Se) and the second element (Mg, Zn) was epitaxially grown on the active layer. At the same time when the crystal was epitaxially grown on the active layer, the excited species of nitrogen molecule was radiated onto the substrate 40 from the ECR cell 35. Thus, a II-VI semiconductor device could be manufactured. It is preferred that the II-VI semiconductor device containing Mg is manufactured by the method using the ECR plasma according to the present invention because the optical characteristic and lifetime of the II-VI compound semiconductor containing Mg is easily affected by impurities as compared with other II-VI compound semiconductors.

While the preferred embodiments of the present invention have been described so far, the present invention is not limited thereto and such a variant is also possible. That is, the GaAs substrate may be replaced with a ZnSe substrate, for example. Further, the excited species of nitrogen molecule may be replaced with excited species of nitrogen atom. Furthermore, excited species of oxygen molecule or oxygen atom may be utilized instead of the excited species of nitrogen molecule. That is, the II-VI compound semiconductor layer can be given a p-type conductivity by the oxygen.

Instead of the process that various elements are deposited on the substrate according to the MBE technique, a gas-source MBE technique, MOMBE technique or technique what might be called a chemical beam epitaxy might be employed in which a cracking cell is utilized to impinge raw material gas upon the substrate surface to decompose the raw material gas on the substrate surface so that elements that are components of the raw material gas are deposited on the substrate surface.

The composition of the II-VI compound semiconductor device is not limited to those of the second and third embodiments and the following variants are also possible by way of example.

That is, the substrate is made of n-GaAs, the first cladding layer is made of n-ZnSe, the active layer is made of Zn(S, Se) and the second cladding layer is made of p-ZnSe or the substrate is made of p-GaAs, the first cladding layer is made of p-ZnSe, the active layer is made of (Cd, Zn)Se or Zn(S, Se) and the second cladding layer is made of n-ZnSe. Further, the substrate is made of p-GaAs, the first cladding layer is made of p-(Mg, Zn)(S, Se), the active layer is made of ZnSe and the second cladding layer is made of n-(Mg, Zn)(S, Se). In the aforesaid embodiments, the method of the present invention is applied to form the p-type compound semiconductor layer.

Having described preferred embodiments of the invention with reference to the accompanying drawings, it is to be understood that the invention is not limited to those precise embodiments and that various changes and modifications could be effected therein by one skilled in the art without departing from the scope of the invention as defined in the appended claims.

## Claims

1. An epitaxial growth apparatus comprising:
a vacuum vessel (2);
a plasma generating apparatus (3) for exciting a doping gas; a source (3, 5) for supplying said doping gas; and a substrate holder (1) for holding a substrate (16) within said vacuum vessel (2) and on which a semiconductor layer grown, wherein said doping gas supply source (3, 5) includes an aperture (6A) for doping said substrate (1) with a part of said doping gas, characterised in that said doping gas supply source (3, 5) comprises further aperture (9) for exhausting a remaining portion of said doping gas into said vacuum vessel (2).

2. Epitaxial growth apparatus according to claim 1, further comprising a means for producing a vacuum in said vacuum vessel in a range of from 10-3 to 10-6 Torr.

3. Epitaxial growth apparatus according to claim 1 or 2, comprising gas control means for controlling the amount of gas supplied from said doping gas supply source (5), to control the amount of doping gas supplied to said plasma generating source (3).

4. Epitaxial growth apparatus according to claim 1, 2 or 3, wherein said vacuum vessel (2) incorporates therein a material source having II- or VI-group element.

5. Epitaxial growth apparatus according to claim 4, wherein said II-group element is at least one of Be, Mg, Zn and Cd, and said VI-group element is at least one of S, Se and Te.

6. Epitaxial growth apparatus according to any one of the preceding claims, wherein said doping gas is nitrogen.

7. Epitaxial growth apparatus according to any one of the preceding claims, wherein said semiconductor layer is grown by a molecular beam epitaxy.

8. An epitaxial growth method comprising the steps of: growing a semiconductor layer on a substrate (1) within a vacuum vessel (2) by an epitaxy method;
doping aid semiconductor layer during or after growth with a part of gas supplied from a doping gas supply source (3, 5); characterised by:
exhausting a remaining gas into said vacuum vessel (2), wherein said gas doped into said semiconductor layer is made at least to be a plasma gas.

9. The epitaxial growth method according to claim 8, wherein a vacuum degree within said vacuum vessel falls in a range of from 10-3 to 10-6 Torr.

10. The epitaxial growth method according to claim 8 or 9, wherein said doping gas is nitrogen.

11. The epitaxial growth method according to claim 8, 9 or 10 , wherein said semiconductor grown on said substrate is made of II- and VI-group elements.

12. The epitaxial growth method according to claim 11, wherein said II-group element is at least one of Hg, Mg, Zn and Cd, and said VI-group element is at least one of S, Se and Te.

13. An epitaxial growth method comprising the steps of: depositing a first element selected from at least one of Hg, Mg, Zn and Cd and a second element selected from at least one of S, Se and Te on a substrate (40) within a vacuum vessel (31) to form a semiconductor layer; and irradiating an excited species of nitrogen, oxygen molecule or atom excited by an electron-cyclotron-resonance (ECR) plasma on said semiconductor layer.

14. The epitaxial growth method according to claim 13, wherein a part of said excited species of nitrogen, oxygen molecule or atom excited by said electron-cyclotron-resonance (ECR) plasma is radiated on said semiconductor layer and other remaining portion is exhausted into said vacuum vessel (31).

15. The epitaxial growth method according to claim 13 or 14, wherein at least Mg is selected as said second element.

16. The epitaxial growth method according to claim 13, 14 or 15, wherein a density at which said excited species of nitrogen, oxygen molecule or atom is radiated on said semiconductor layer is 10⁻⁶ to 10⁻³ times the density at which said first element is deposited on said semiconductor layer.
